# EUROPEAN PATENT APPLICATION

(11) **EP 1 986 085 A2**
(43) Date of publication of application: **29.10.2008**
(21) Application number: 07119510.1
(22) Date of filing: 29.10.2007
(51) Int. Cl.: G06F 3/048, G06F 3/033, G06F 3/038, G06F 1/16

(54) **Electrostatic pad apparatus and information processing apparatus**

(30) Priority: 27.04.2007 JP 2007119842
(71) Applicant: Kabushiki Kaisha Toshiba, Minato-ku, Tokyo 105-8001 (JP)
(72) Inventor: Nakamura, Toshikatsu Toshiba Corporation, Minato-ku, Tokyo (JP)
(74) Representative: Henkel, Feiler & Hänzel

(57) **Abstract**

According to one embodiment, an electrostatic pad apparatus (60) comprising: a pad portion that includes a touch detecting area having a ringed shape, the touch detecting area being partitioned into a plurality of areas (61,62,63,64) including a first area (63) and a second area (64), the areas being arranged along a circumferential direction of the touch detecting area; and a controller that outputs a first command when a touch operation is input to the first area and outputs a second command when a touch operation is input to the second area.

## Description

### CROSS-REFERENCE TO RELATED APPLICATIONS

This application is based upon and claims the benefit of priority from Japanese Patent Application No. 2007-119842, filed April 27, 2006, the entire contents of which are incorporated herein by reference.

### BACKGROUND

### 1. Field

One embodiment of the invention relates to an electrostatic pad apparatus and an information processing apparatus including the apparatus.

### 2. Description of the Related Art

Generally, in an information processing apparatus such as a personal computer, there is used not only a keyboard, a mouse but also a touch detecting type electrostatic pad apparatus for detecting a touching operation by the finger of a user such as a touch pad.

Similar to a mouse, a touch pad functions as a pointing device utilizing relative position coordinates. A user places the finger on a touch detecting area of a touch pad and moves the finger along the touch detecting area. The touch pad detects the touching operation on the touch detecting area, that is, a movement of the finger of the user on the touch detecting area and inputs a detecting signal to a computer. Thereby, a position of a cursor on a display screen can be moved in accordance with the touching operation on the touch detecting area. A speed of moving the mouse cursor is determined by a speed of moving the finger on a surface of the touch detecting face.

JP-T-2005-507112 discloses a portable media player including a touch pad. According to the portable media player, an operation of selecting a specific data item from a menu screen can be carried out in accordance with a movement of the finger on the touch pad.

However, according to the touch pad of Patent Reference 1, a total of a touch detecting area thereof functions as one input area. Therefore, when the movement of the finger by a user stays the same, even when an operation of moving the finger is carried out at any portion in the touch detecting area, a function executed by a portable media player stays the same. Therefore, a kind of the function capable of instructing execution to the portable media player by operating the touch pad by the user is limited.

In a computer in recent times, various kinds of media of not only a music data but also a dynamic image data, a TV broadcasting program, a static image, a game, an internet content are dealt with. In a computer dealing with a number of kinds of media, it is necessary for a user to instruct a computer to execute various functions. Therefore, it is necessary to realize a new electrostatic pad apparatus capable of easily inputting instructions of executing various functions to a computer.

### SUMMARY

One of objects of the present invention is to provide an electrostatic pad apparatus capable of instructing an information processing apparatus to execute various functions in accordance with a touching operation by a user and an information processing apparatus using the electrostatic pad apparatus. According to an aspect of the present invention , there is provided an electrostatic pad apparatus comprises a pad portion that includes a touch detecting area having a ringed shape, the touch detecting area being partitioned into a plurality of areas including a first area and a second area, the areas being arranged along a circumferential direction of the touch detecting area; and a controller that outputs a first command when a touch operation is input to the firs area and outputs a second command when a touch operation is input to the second area.

### BRIEF DESCRIPTION OF THE SEVERAL VIEWS OF THE DRAWINGS

A general architecture that implements the various feature of the invention will now be described with reference to the drawings. The drawings and the associated descriptions are provided to illustrate embodiments of the invention and not to limit the scope of the invention.

Fig.1 is an exemplary perspective view showing an outlook of a computer according to an embodiment of the invention.

Fig.2 is an exemplary plane view viewing an AV controller including an electrostatic pad apparatus provided at the computer of Fig.1 from an upper face side.

Fig.3 is an exemplary sectional view of the AV controller of Fig.2.

Fig.4 is an exemplary view for explaining a dead zone arranged at a touch detecting area of the AV controller of Fig.2.

Fig.5 is an exemplary perspective view showing an outlook of the AV controller of Fig.2.

Fig.6 is an exemplary disassembled perspective view of the AV controller of Fig.2.

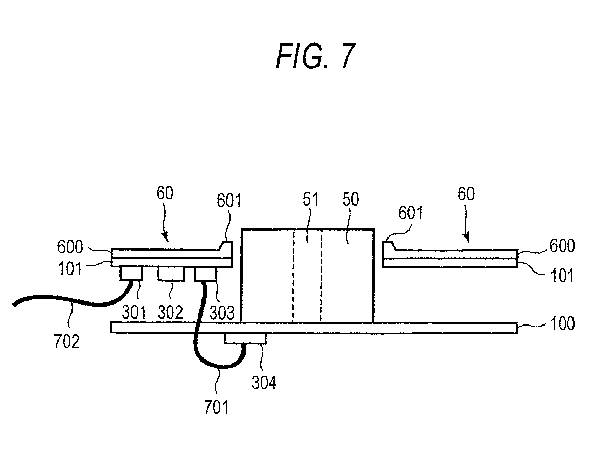

Fig.7 is an exemplary view showing an example of a connecting relationship between an electrostatic pad apparatus and a push button switch portion provided at inside of the AV controller of Fig.2.

Fig.8 is a block diagram showing an example of a system constitution of the computer of Fig.1.

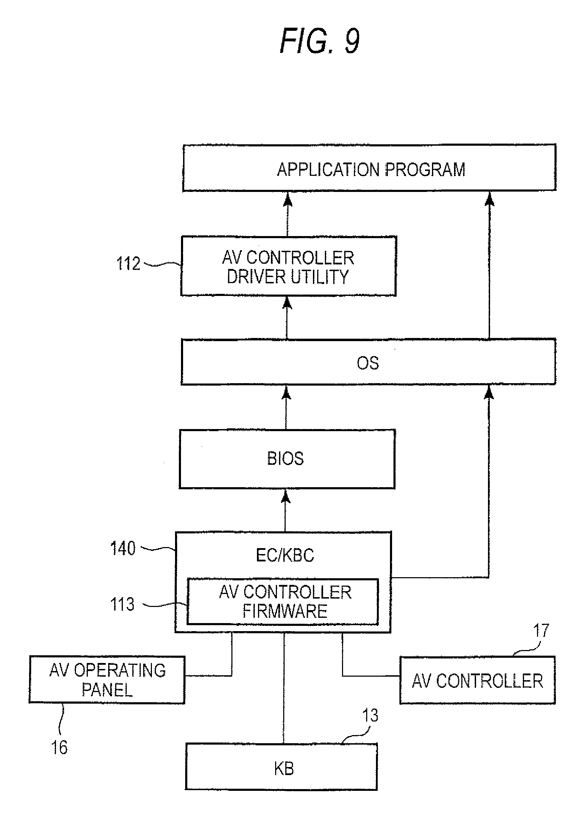

Fig.9 is an exemplary diagram for explaining a relationship between an exemplary hardware and a software for controlling the AV controller of Fig.2.

Fig.10 is an exemplary block diagram showing a function constitution of a program for controlling the AV controller of Fig.2.

Fig.11 is an exemplary view showing an example of an AV controller setting screen displayed by the program of Fig.10.

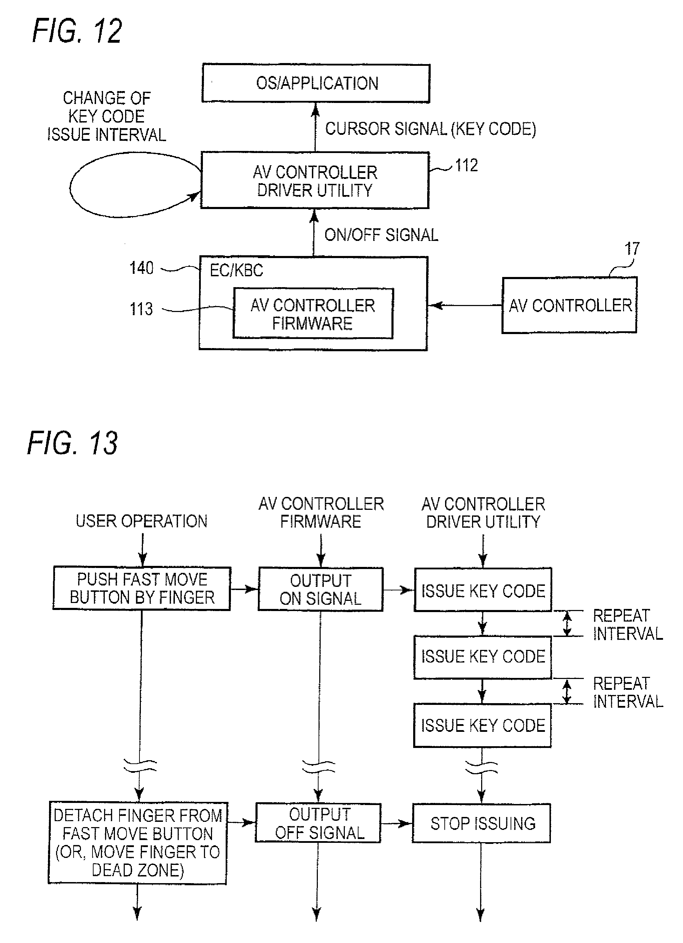

Fig.12 is an exemplary block diagram showing an example of a software constitution for executing a cursor moving processing in accordance with an operation of touching an electrostatic pad apparatus provided at an AV controller 17 of Fig.2.

Fig.13 is an exemplary diagram showing a behavior of a key code generation repeating processing executed by the program of Fig.10.

Fig.14 illustrates views showing a relationship between an operation of touching an electrostatic pad apparatus provided at the AV controller 17 of Fig.2 and a cursor moving processing in correspondence with the touch operation.

Fig.15 is an exemplary block diagram showing an example of a software constitution for executing a cursor moving processing in accordance with an operation of touching an electrostatic pad apparatus provided at the AV controller 17 of Fig.2.

Fig.16 is an exemplary flowchart showing an example of a procedure of a cursor moving processing executed by the program of Fig.10.

Fig.17 is an exemplary flowchart showing other example of a procedure of a cursor moving processing executed by the program of Fig.10.

### DETAILED DESCRIPTION

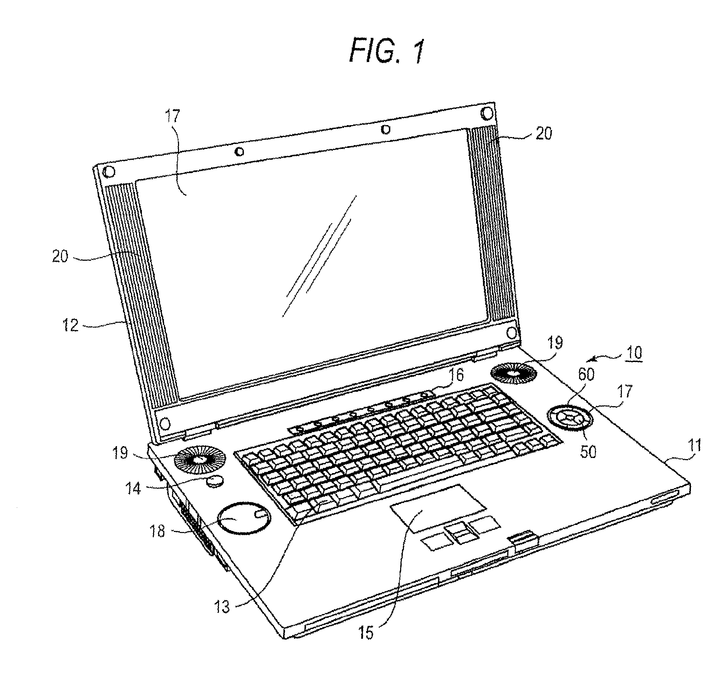

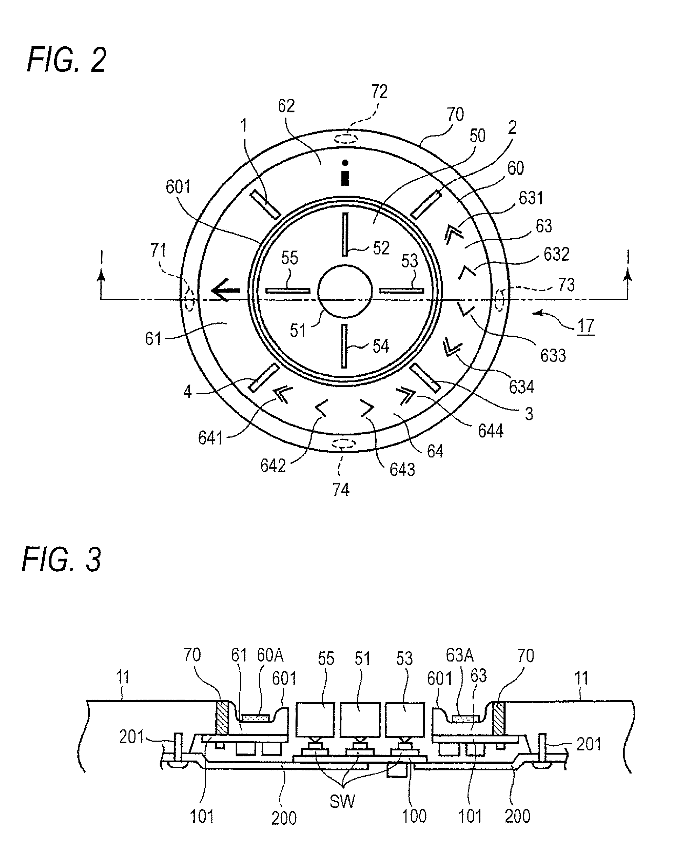

Embodiments of the invention will be explained in reference to the drawings as follows. First, a constitution of an information processing apparatus according to an embodiment of the invention will be explained in reference to Fig.1 and Fig.2. The information processing apparatus is realized as a battery drivable notebook type portable personal computer 10.

Fig.1 is a perspective view in a state of opening a display unit of the computer 10. The computer 10 is constituted by a computer main body 11 and a display unit 12. The display unit 12 is integrated with a display apparatus constituted by LCD (Liquid Crystal Display) 17, and a display screen of the LCD 17 is disposed substantially at a center of the display unit 12. Both sides of the LCD 17 are arranged with a pair of speakers (tweeters) 20.

The display unit 12 is attached to the computer main body 11 pivotably between an open position of exposing an upper face of the computer main body 11 and a close position of covering the upper face by the display unit 12. The computer main body 11 includes a cabinet in a shape of a thin box capable of mounting a battery removably.

An upper face of the cabinet of the computer main body 11 is arranged with a keyboard 13, a touch pad 15, an audio and video (AV) operating panel 16, an AV controller 17, a volume control dial 18, and a pair of speakers 19 and the like. The keyboard 13 includes a plurality of keys including four upper and lower and left and right direction keys and other various keys (alphabet key, number key, auxiliary key and the like).

The computer 10 is provided with an AV function for reproducing various media of TV broadcasting program, dynamic image data, static image, music. The AV operating panel 16 includes a plurality of buttons for controlling an AV function of the computer 10. Each of the buttons is constituted by an electrostatic switch. A center of each electrostatic switch is arranged with an LED light transmitting portion. Light from LED provided in correspondence with each electrostatic switch is emitted to outside by way of the corresponding LED light transmitting portion.

A group of buttons of the AV operating panel 16 includes a TV button, a CD/DVD button, an LED ON/OFF button and the like. The TV button is a button of instructing to start a TV function for seeing and hearing or recording a TV broadcasting program. The CD/DVD button is a button for instructing to start a CD/DVD function for reproducing a content stored to CD media or DVD media. The LED ON/OFF button is a button for controlling respective LEDs at inside of the AV operating panel 16 and respective LEDs arranged at inside of the AV controller 17.

The AV controller 17 is an input apparatus for controlling the AV function and the like of the computer 10, and is supported by the cabinet of the main body 11. The AV controller 17 inputs various commands with regard to control of the AV function and the like to the computer 10.

The AV controller 17 includes an electrostatic pad apparatus 60 for detecting a touch position on a touch detecting area in a ring-like shape, and a push button switch portion 50 in a circular shape arranged at a center of the electrostatic pad apparatus 60. The AV controller 16 is allocated with various functions necessary for controlling an AV software for executing the above-descried AV function. A plurality of push buttons of the push button switch portion 50 are arranged at inside of an inner periphery of the AV controller 17, and a touch detecting area of the electrostatic pad apparatus 60 is arranged at inside of an outer periphery of the AV controller 17. The touch detecting area is partitioned into a plurality of areas respectively allocated with a plurality of functions. A user can input a group of commands for instructing the AV software to execute various functions by only operating the electrostatic pad apparatus 60 and the push button switch portion 50 at inside of the AV controller 17 by one hand without operating the keyboard 13 and the touch pad 15.

Fig.2 shows a constitution example of the AV controller 17.

The push button switch portion 50 is provided with an OK button (enter button) 51, and four direction buttons (arrow mark buttons) 52 through 55.

The OK button 51 is constituted by a push button switch and is used for inputting a key code the same as a key code allocated to an enter key at inside of the keyboard 13 to the computer 10. The four direction buttons 52 through 53 are constituted by four push button switches contained at inside of one cover. In other words, the four direction buttons 52 through 55 are realized as one cross key switch.

The direction key 52 is a push button allocated with an upper direction key function for moving an operation object position or a cursor on a display screen in an upper direction, and used for inputting a key code the same as the key code allocated to an upper arrow mark key "↑" at inside of the key board 13 to the computer 10.

The direction button 53 is a push button allocated with an right direction key function for moving an operation object position or a cursor on a display screen in a right direction and used for inputting a key code the same as the key code allocated to an right arrow mark key "→" at inside of the key board 13 to the computer 10.

The direction button 54 is a push button allocated with a lower direction key function for moving an operation object position or a cursor on a display screen in a lower direction and used for inputting a key code the same as the key code allocated to a lower arrow mark key "↓" at inside of the key board 13 to the computer 10.

The direction button 55 is a push button allocated with a left direction key function for moving an operation object position or a cursor on a display screen in a left direction and used for inputting a key code the same as the key code allocated to a left arrow mark key "←" at inside of the key board 13 to the computer 10.

The electrostatic pad apparatus 60 includes a touch detecting area in a ring-like shape surrounding the push button switch portion 50. Specifically, the electrostatic pad apparatus 60 includes a pad portion functioning as a touch detecting area, and an electrostatic sensor for detecting a position (touch position) of the finger of a user on the touch detecting area of the pad portion in accordance with a change in an electrostatic capacitance. An operation in which a user touches the touch detecting area by the finger is referred to as a touch operation.

The pad portion is constituted by, for example, an dielectric substance, and a surface of the pad portion functions as the touch detecting area. The surface of the pad portion, that is, the touch detecting area is provided with a ring-like and a circular shape. The touch detecting area is partitioned into four areas 61, 62, 63, 64 aligned to arrange along a circumferential direction thereof. The four areas 61, 62, 63, 64 are input areas (areas for carrying out the touch operation by the user) allocated with functions different from each other.

Further, on the touch detecting area, projected portions are formed at boundary positions between respective two areas contiguous to each other. That is, a projected portion 1 a longitudinal direction of which is extended along a radius direction of the touch detecting area is arranged between the areas 61 and 62. Further, a projected portion 2 a longitudinal direction of which is extended along the radius direction of the touch detecting area is arranged between the areas 62 and 63. Similarly, a projected portion 3 a longitudinal direction of which is extended along the radius direction of the touch detecting area is arranged between the areas 63 and 64. Further, a projected portion 4 a longitudinal direction of which is extended along the radius direction of the touch detecting area is arranged also between the areas 64 and 61. By providing the projected portions 1 through 4, when a user operates to touch a certain area by the finger, it can be prevented that the finger erroneously touches an area contiguous thereto or the finger touches two contiguous areas simultaneously.

The area 61 is allocated with a "return" function for instructing a software group such as an AV software to return to a display content immediately therebefore. That is, the area 61 inputs a command of instructing to execute the "return" function to the computer 10 in accordance with a touch operation on the area 61. When the finger of the user is touched onto the area 61, in response to the touch operation, for example, the electrostatic sensor at inside of the electrostatic pad apparatus 60 outputs a signal indicating that the area 61 is touched as a command for instructing the software group to execute the "return" function. In this way, the area 61 functions as the "return" button for instructing to execute the "return function".

The area 62 is allocated with a "MORE INFO" function for instructing a software group such of, for example, an AV software to display further detailed information related to a display item. That is, the area 62 inputs a command for instructing to execute the "MORE INFO" function in accordance with the touching operation on the area 62. When the finger of the user is touched onto the area 62, in response to the touch operation, the electrostatic sensor at inside of the electrostatic pad apparatus 60 outputs a signal indicating that the area 62 is touched, for example, as a command for instructing to execute the "MORE INFO" function to the software group. In this way, the area 62 functions as the "MORE INFO" button for instructing to execute the "MORE INFO" function.

The area 63 is allocated with a first "FAST MOVE BUTTON" function for moving an operation object position or a cursor on a display screen in a vertical direction (upper or lower direction). That is, the area 63 inputs a command for instructing to execute the first "FAST MOVE BUTTON" function in accordance with a touch operation on the area 63 to the computer 10.

The first "FAST MOVE BUTTON" function is used as a function for scrolling a display data such as an operation menu displayed by, for example, an AV software in a vertical direction in accordance with an touch operation on the area 63. In response to the touch operation on the area 63, the electrostatic sensor at inside of the electrostatic pad apparatus 60 outputs a signal indicating that the area 63 is operated to touch as a command of indicating to scroll an operation object position or a cursor on a display screen in the vertical direction. A user can navigate the menu screen while scrolling a menu screen displayed by the AV software in an upper direction or a lower direction by only touching the area 63 by the finger.

In order to realize the first "FAST MOVE BUTTON" function, the area 63 is partitioned into four subareas, that is, two upper direction key areas 631, 632 and two lower direction key areas 633, 634. The subareas 631 through 634 are arranged to align in one direction. The subareas 631 through 634 respectively function as FAST MOVE BUTTONs for moving an operation object position or a cursor on a display screen in an upper direction or a lower direction. The subarea described with marks "«"and"»" are allocated with a function for moving an operation object position or a cursor on a display screen in an upper or lower direction at a speed faster than the subareas described with marks "<"and">".

That is, respectives of the upper direction key areas 631, 632 are areas allocated with an upper direction key function for moving an operation object position of a cursor on a display screen in an upper direction, and used for inputting a key code the same as the key code allocated with the upper arrow mark key "↑" at inside of the key board 13. In this case, the upper direction key area 631 is allocated with a function of moving an operation object position or a cursor in the upper direction at a speed higher than that of the upper direction key area 632. That is, during a time period in which the upper direction area 632 is being touched, the key code the same as the key code allocated to the arrow mark key "↑" at inside of the keyboard 13 is inputted to the software repeatedly at a first interval (also referred as a repeat interval). During a time period in which the upper direction key area 631 is being touched, the key code the same as the key code allocated to the upper arrow mark "↑" at inside of the keyboard 13 is inputted to the software repeatedly at a second time interval shorter than the first time interval.

In this way, the upper direction key area 632 inputs a command of instructing to move an operation object position or a cursor on a display screen in the upper direction by the first speed to the computer 10 in accordance with the touch operation on the upper direction key area 632. Further, the upper direction key area 631 inputs a command of instructing to move an operation object position of a cursor on a display screen in the upper direction by the second speed faster than the first speed in accordance with the touch operation on the upper direction key area 631. The electrostatic sensor at inside of the electrostatic pad apparatus 60 outputs a detecting signal indicating that the upper direction key area 632 is touched in response to the touching operation on the upper direction key area as a command for instructing the computer 10 to move the operation object position or the cursor in the upper direction by the first speed. The detecting signal outputted by the electrostatic sensor is a signal indicating the touch position on the touch detecting area. The command is transmitted to CPU at inside of the computer 10, and a processing related to the command is executed by a software executed by CPU.

Further, in response to the touch operation on the upper direction key area 631, the electrostatic sensor at inside of the electrostatic pad apparatus 60 outputs a detecting signal indicating that the upper direction key area 631 is touched as a command of instructing the computer 10 to move the operation object position or the cursor in the upper direction by the second speed.

Respectives of the lower direction key areas 633, 634 are areas allocated with a lower direction key function for moving an operation object position or a cursor on a display screen in the lower direction, and used for inputting a key code the same as the key code allocated to the lower arrow mark key "↓" at inside of the keyboard 13. In this case, the lower direction key area 634 is allocated with a function for moving the operation object position or the cursor in the lower direction by a speed faster than the lower direction key area 633. That is, during a time period in which the lower direction key area 633 is being touched, a key code the same as the key code allocated to the lower arrow mark key "↓" at inside of the keyboard 13 is inputted to a software repeatedly by a first repeat interval. During a time period in which the lower direction key area 634 is being touched, the key code the same as the key code allocated to the lower arrow mark key "↓" at inside of the keyboard 13 is inputted to the software repeatedly at a second repeat interval shorter than the first repeat interval.

In this way, the lower direction key area 633 inputs a command of instructing to move the operation object position or the cursor on the display screen in the lower direction by the first speed to the computer 10. The lower direction key area 634 inputs a command of instructing to move the operation object position or the cursor on the display screen in the lower direction by the second speed faster than the first speed. The electrostatic sensor at inside of the electrostatic pad apparatus 60 outputs a detecting signal indicating that the lower direction key area 633 is touched in response to the touch operation on the lower direction key area 633 as a command of instructing to move the position object position or the cursor in the lower direction by the first speed. Further, in response to the touch operation on the lower direction key area 634, the electrostatic sensor at inside of the electrostatic pad apparatus 60 outputs a detecting signal indicating that the lower direction key are 634 is touched as a command of instructing to move the operation object position or the cursor in the lower direction by the second speed.

A user can navigate a menu screen while scrolling the menu screen displayed by the AV software in the upper direction or the lower direction by a preferred speed by only touching the four subareas 631, 632, 633, 634 at inside of the area 63 allocated with the first "FAST MOVE BUTTON" function selectively by the finger.

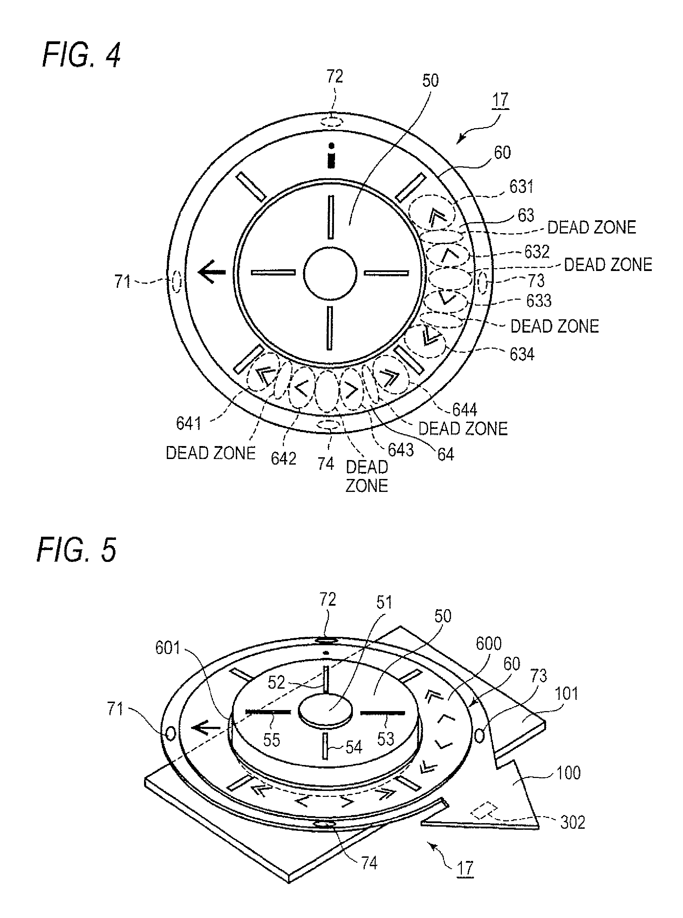

Further, it the area 63, as shown by Fig.4, an area (dead zone) in which it is not detected that the area 63 is touched between the two contiguous subareas. That is, the three dead zones are arranged in the area 63. One thereof is disposed between the subareas 631, 632, other thereof is disposed between the subareas 632 and 633, and still other thereof is disposed between the subareas 633 and 634. An area of a center dead zone in the three dead zones, that is, the dead zone disposed between the subareas 632 and 633 is wider than those of the other two dead zones.

The electrostatic sensor at inside of the electrostatic pad apparatus 60 outputs a signal indicating that the finger of the user is detached from above the area 63 when the finger of the user is moved above the dead zone. Therefore, by arranging the dead zone between the two contiguous subareas, the user can move the operation object position or the cursor or temporarily stop the movement by simply sliding the position of the finger while placing the finger on the area 63 without detaching the finger from the area 63. Further, erroneous operation by simultaneously touching the finger of the user simultaneously to the contiguous two subareas can also be prevented.

Particularly, since the center zone is wide, the center dead zone can effectively be used as a neutral finger position at which the operation object position or the cursor is not moved. A user can move the operation object position or the cursor on the display screen in the upper direction or the lower direction by placing the finger on the center dead zone and moving the finger in the upper direction or the lower direction therefrom. Further, the user can freely change a speed of moving the operation object position or the cursor on the display screen in the upper direction by only placing the finger on the dead zone between the subareas 631, 632 and sliding the finger in the upper direction or the lower direction therefrom. Similarly, the user can freely change a speed of moving the operation object position or the cursor on the display screen in the lower direction by only placing the finger on the dead zone between the subareas 633 and 634 and sliding the finger in the upper direction or the lower direction therefrom.

The area 64 is allocated with a second "FAST MOVE BUTTON" function for moving an operation object position or a cursor on a display screen in a horizontal direction (left or right direction). That is, the area 64 inputs a command for instructing to execute the second "FAST MOVE BUTTON" function to the computer 10 in accordance with a touch operation on the area 64.

The second "FAST MOVE BUTTON" function is used as a function of scrolling a display data such as an operation menu indicated by, for example, an AV software in the horizontal direction in accordance with a touch operation on the area 64. In response to the touch operation on the area 64, the electrostatic sensor at inside of the electrostatic pad apparatus 60 outputs a signal indicating that the area 64 is operated to touch, for example, as a command of instructing to scroll the operation object position or the cursor on the display screen in the horizontal direction. A user can navigate a menu screen indicated by the AV software while scrolling the menu screen in the left direction or the right direction.

In order to realize the second "FAST MOVE BUTTON" function, as shown by Fig.2, the area 64 is partitioned into four subareas, that is, two left direction key areas 641, 642 and two right direction key areas 643, 644. The subareas 641 through 644 respectively function as FAST MOVE BUTTONS for moving the operation object position or the cursor on the display screen in the left direction or the right direction. The subareas described with marks "<<"and">>" are allocated with a function for moving the operation object position or the cursor on the display screen in the left or the right direction at a speed faster than that of the subareas described with marks "<"and">".

That is, respectives of the left direction key areas 641, 642 are areas allocated with a left direction key function for moving the operation object position or the cursor on the display screen in the left direction, and used for inputting the key code the same as the key code allocated to a left arrow mark key "←" at inside of the keyboard 13. In this case, the left direction key area 641 is allocated with a function for moving the operation object position or the cursor in the left direction by a speed faster than that of the left direction key area 642. That is, during a time period in which the left direction key area 642 is being touched, the key code the same as the key code allocated to the left arrow mark key "←" at inside of the keyboard 13 is inputted to a software repeatedly by a first repeat interval. During a time period in which the left direction key area 641 is being touched, the key code the same as the key code allocated to the left arrow mark key "←" at inside of the keyboard 13 is inputted to the software repeatedly at a second repeat interval shorter than the first repeat interval.

In this way, the left direction key area 642 inputs a command of instructing to move the operation object position or the cursor on the display screen in the left direction by the first speed in accordance with the touch operation on the left direction key area 642 to the computer 10. Further, the left direction key area 641 inputs a command of instructing to move the operation object position or the cursor on the display screen in the left direction by a second speed faster than the first speed to the computer 10 in accordance with the touch operation on the left direction key area 641. The electrostatic sensor at inside of the electrostatic pad apparatus 60 outputs a detecting signal indicating that the left direction key area 642 is touched as a command of instructing to move the operation object position or the cursor in the left direction by the first speed in response to the touch operation on the left direction key area 642. Further, in response to the touch operation on the left direction key area 641, the electrostatic sensor at inside of the electrostatic pad apparatus 60 outputs a detecting signal indicating that the left direction key area 641 is touched as a command of instructing to move the operation object position or the cursor in the left direction by the second speed.

Respectives of the right direction key areas 643, 644 are areas allocated with a right direction key function for moving an operation object position or a cursor on a display screen in the right direction, and used for inputting a key code the same as the key code allocated to the right arrow mark key "→" at inside of the key board 13. In this case, the right direction key area 644 is allocated with a function of moving the operation object position or the cursor in the right direction by a speed faster than that of the right direction key area 643. That is, during a time period in which the right direction key area 643 is being touched, a key code the same as the key code allocated to the right arrow mark key "→" at inside of keyboard 13 is inputted to a software repeatedly at a first repeat interval. During a time period in which the right direction key area 644 is being touched, the key code the same as the key code allocated to the right arrow mark key "→" at inside of the keyboard 13 is inputted to the software repeatedly by a second repeat interval shorter than the first repeat interval.

In this way, the right direction key area 643 inputs a command of instructing to move the operation object position or the cursor on the display screen in the right direction by the first speed to the computer 10 in accordance with the touch operation on the right direction key area 643. Further, the right direction key area 644 inputs a command of instructing to move the operation object position or the cursor on the display screen in the right direction by the second speed faster than the first speed in accordance with the touch operation on the right direction key area 644. The electrostatic sensor at inside of the electrostatic pad apparatus 60 outputs a detecting signal indicating that the right direction key area 643 is touched in response to the touch operation on the right direction key area 643 as a command of instructing to move the operation object position or the cursor in the right direction by the first speed. Further, in response to the touch operation on the right direction key area 644, the electrostatic sensor at inside of the electrostatic pad apparatus 60 outputs a detecting signal indicating that the right direction key area 644 is touched as a command of instructing to move the operation object position or the cursor in the right direction by the second speed.

A user can navigate a menu screen while scrolling the menu screen indicated by the AV software in the left direction or the right direction by a preferred speed by only selectively touching the four subareas 641, 642, 643, 644 at inside of the area 64 allocated with the second "FAST MOVE BUTTON" function by the finger.

Further, also in the area 64, as shown by Fig.4, an area (dead zone) in which the touching operation is not detected is arranged between the contiguous subareas. That is, in the area 64, three dead zones are arranged. One thereof is disposed between the subareas 641 and 642, other thereof is disposed between the subareas 642 and 643, and still other areas thereof is arranged between the subareas 643 and 644. An area of a center dead zone in the three dead zones, that is, the dead zones disposed between the subareas 642, 643 is wider than the other two dead zones.

The electrostatic sensor at inside of the electrostatic pad apparatus 60 outputs a signal indicating that the finger of the user is detached from above the area 64 when the finger of the user is moved to above the dead zone. Therefore, the user can move the operation object position or the cursor on the display screen in the left direction or the right direction by a desired speed or temporarily stop the movement of the position object position or the cursor by simply moving the position of the finger in a state of placing the finger on the area 64 without detaching the finger from the area 64. Particularly, the center dead zone is wide, and therefore, the center dead zone can be effectively used as a neutral finger position at which the operation object position or the cursor is not moved. The user can move the operation object position or the cursor on the display screen in the left direction or the right direction by placing the finger on the center dead zone and moving the finger in the left direction or the right direction therefrom. The user can freely change the moving speed of the operation object position or the cursor on the display screen in the left direction by placing the finger on the dead zone between the subareas 641 and 642 and sliding the finger in the left direction or the right direction therefrom. Similarly, the user can freely change the moving speed of the operation object position or the cursor on the display screen in the right direction by placing the finger on the dead zone between the subareas 643 and 644 and sliding the finger in the left direction or the right direction therefrom.

Further, in the AV controller 17, four light emitting portions (LED) 71, 72, 73, 74 are provided contiguously to respectives of the four areas 61, 62, 63, 64 at inside of the electrostatic pad apparatus 60. According to the electrostatic pad apparatus 60, different from a push button switch, even when a user touches the respective areas 61, 62, 63, 64 by the finger, there is not a reaction from the respective areas in correspondence with the touch operation. The four LEDs 71, 72, 73, 74 are used for informing the user that respectives of the four areas 61, 62, 63, 64 are operated to touch. Respectives of the four LEDs 71, 72, 73, 74 are switched on or switched off in response to a touching operation on the corresponding areas. The four LEDs 71, 72, 73, 74 are arranged, for example, on the outer peripheral side of the touch detecting area in the ring-like shape of the electrostatic pad apparatus 60. Specifically, an LED light transmitting portion 70 in a ring-like shape is arranged on the outer peripheral side of the touch detecting area in the ring-like shape. A lower side of the LED light transmitting portion 70 is arranged with the four LEDs 71, 72, 73, 74 in correspondence with respectives of the four areas 61, 62, 63, 64. The LED light transmitting portion 70 in the ring-like shape emits light from the respective LEDs to outside.

Further, the four LEDs 71, 72, 73, 74 may be arranged on the inner peripheral side of the touch detecting area in the ring-like shape.

Fig.3 is a sectional view of the AV controller 17 taken along a line I-I of Fig.2.

The OK button (enter button) 51 and the four direction buttons (arrow mark buttons) 52 through 55 at inside of the push button switch portion 50 are provided above a switch board 100. That is, five switches (mechanical switches) SW respectively in correspondence with the OK button (enter button) 51 and the four direction buttons (arrow mark buttons) 52 through 55 are provided above the switch board 100, and the OK button (enter button) 51 and the four direction buttons (arrow mark buttons) 52 through 55 are respectively arranged above the switches SW. The switch board 100 is attached with a switch board support sheet 200, and the switch board support sheet 200 is supported by the cabinet of the computer main body 11 by a fixing screw 201.

The ring-like pad portion of the electrostatic pad apparatus 60 is provided above an electrostatic sensor board 101. An opening is provided at a center of the electrostatic sensor board 101 and the push button switch portion 50 is arranged at inside of the opening. A surface sheet 60A is arranged on a surface of the pad portion, that is, on a surface of the touch detecting area.

A surface of the push button switch portion 50 is arranged at a position higher than a surface of the electrostatic pad apparatus 60, that is, the surface of touch detecting area. Thereby, a stepped difference is produced between the surface of the push button switch portion 50 and the surface of the electrostatic pad apparatus 60, and therefore, an erroneous operation by touching the finger of the user simultaneously to both of the touch detecting areas of the push button switch portion 50 and the electrostatic pad apparatus 60 can be made to be difficult to be brought about. Further, by the stepped difference, respective strokes of the OK button (enter button) 51 and the four direction buttons (arrow mark buttons) 52 through 55 at inside of the push button switch portion 50 can sufficiently be ensured.

Further, a ring-like projected portion 601 is formed along an inner periphery of the touch detecting area of the pad portion to surround the push button switch portion 50. By the ring-like projected portion 601, when the user pushes any of the four direction buttons (arrow mark buttons) 52 through 55, the finger of the user can be prevented from erroneously touching the touch detecting area.

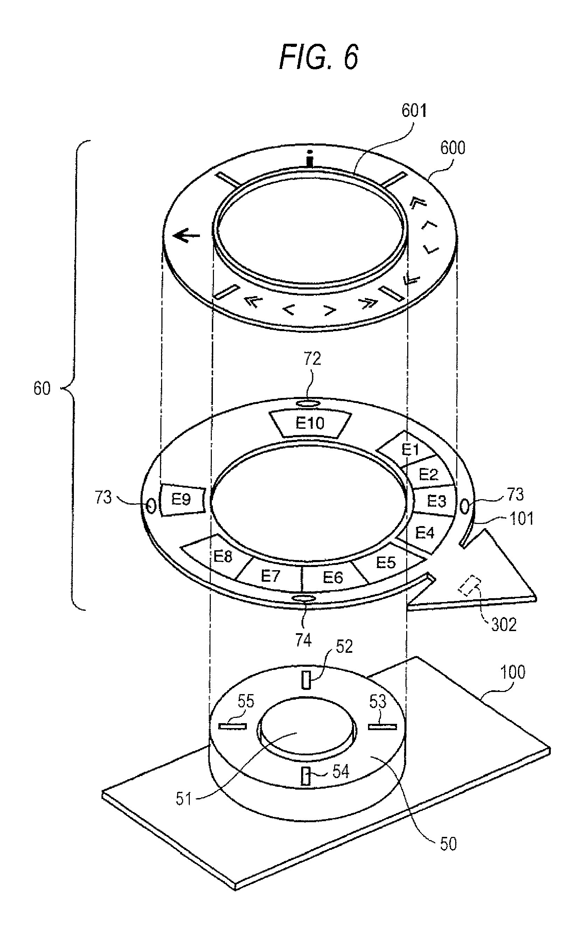

Next, an example of a structure of the AV controller 17 will be explained in reference to Fig.5 and Fig.6. Fig.5 is a perspective view showing an outlook of the AV controller 17, Fig.6 is a disassembled perspective view of the AV controller 17.

The push button switch portion 50 is provided above the switch board 100, and a ring-like pad portion 600 is provided above the electrostatic sensor board 101. A surface of the ring-like pad portion 600 is used as the touch detecting area mentioned above. The ring-like projected portion 601 mentioned above is formed above the surface of the ring-like pad portion 600 along an inner periphery thereof. The electrostatic pad apparatus 60 is constituted by the electrostatic sensor board 101 and the ring-like pad portion 600 arranged above the electrostatic sensor board 101.

A center of the electrostatic sensor board 101 is provided with an opening in a circular shape having a size the same as that of an opening in a circular shape provided at a center of the ring-like pad portion 600. The electrostatic pad apparatus 60 is arranged above the switch board 100 such that the push button switch portion 50 is inserted into the opening of the center of the electrostatic sensor board 101.

A plurality of electrostatic sensor electrodes E1 through E10 are arranged above a surface of the electrostatic sensor board 101 to be opposed to a back face of the ring-like pad portion 600. The electrostatic sensor electrodes E1 through E10 are arranged to align on a circumference along a surrounding of the circular opening provided at the center of the electrostatic sensor board 101. The electrostatic sensor electrodes E1 through E10 function as the electrostatic sensors mentioned above in cooperation with a control circuit 302 provided at, for example, a back face side of the electrostatic sensor board 101. The control circuit 302 is used as a control circuit common to the push button switch portion 50 and the electrostatic pad apparatus 60, and a switch signal outputted from the push button switch portion 50 and a detecting signal outputted from the electrostatic pad apparatus 60 are transmitted to the computer 10 by way of the control circuit 302. When a certain button (OK button 51, direction buttons 52, 53, 54, 54, "return" button 61, "MORE INFO" button 62, FAST MOVE BUTTON groups 631 through 634, 641 through 644 disposed at inside of the AV controller 17 is pushed, the control circuit 302 outputs, for example, a signal indicating the push button (ON signal). The ON signal indicates a button number for identifying the push button, or a coordinates position of the push button. Further, when the finger is detached from the "MORE INFO" button 62, or the FAST MOVE BUTTON groups 631 through 634, 641 through 644, the control circuit 302 outputs a signal indicating the button from which the finger is detached (OFF signal). Also the OFF signal indicates the button number for identifying the push button, or the coordinates position of the push button.

The electrostatic sensor electrodes E1 through E4 are a group of electrodes for detecting a position of the finger and a movement of the finger above the area 63 allocated with the first "FAST MOVE BUTTON" function, and is opposed to a back face of the area 63 of the pad portion 600. The electrostatic sensor electrodes E1 through E4 are used for detecting that at any of the subareas 631 through 634 and the dead zones at inside of the area 63, the finger of the user is disposed. A detection of whether the position of the finger is disposed at any of the subareas 631 through 634, and whether the finger is placed above the dead zone can be carried out based on, for example, a distribution of electrostatic capacitances detected by respectives of the electrostatic sensor electrodes E1 through E4. Naturally, shapes of respective electrodes to be arranged at inside of the area 63, a number of pieces of the electrodes to be arranged at inside of the area 63, and positions of arranging respectives of the electrodes and the like are not limited to the above-described example but there may be constituted a structure capable of detecting that at any of the subareas 631 through 634 and the dead zones the finger of the user is disposed. For example, there may also be constructed a constitution in which a number of electrodes of a number exceeding 4 constituting a number of pieces of the subareas at inside of the area 63 is arranged, or a constitution in which the electrodes are arranged only on respective lower sides of the subareas 631 through 634 and the electrodes are not on lower sides of the dead zones. Further, it can be detected that at any of the subareas 631 through 634 and the dead zones at inside of the area 63, the finger of a user is disposed by using a total of 7 pieces of electrodes of 4 pieces of electrodes in correspondence with respectives of the subareas 631 through 634 and 3 electrodes in correspondence with 3 dead zones.

The electrostatic sensor electrodes E5 through E8 are a group of electrodes for detecting the position and the movement of the finger above the area 64 allocated with the second "FAST MOVE BUTTON" function and are opposed to a back face of the area 64 of the ring-like pad portion 600. The electrostatic sensor electrodes E5 through E8 are used for detecting that at any of the subareas 641 through 644 and the dead zones at inside of the area 64, the finger of the user is disposed. Also the constitution of the electrostatic sensor electrodes E5 through E8 is not limited to the example of Fig.6.

The electrostatic sensor electrode E9 is opposed to a back face of the area 61 allocated with the "return" function for detecting whether the area 61 is touched by the finger. Further, the electrostatic sensor electrode E10 is opposed to a back face of the area 62 allocated with the "MORE INFO" function for detecting whether the area 62 is touched by the finger.

Further, LEDs 71 through 74 mentioned above are provided on the surface of the electrostatic sensor board 101. Further, LEDs 71 through 74 may be arranged on a back face side of the electrostatic sensor board 101 and light from LEDs 71 through 74 may be guided to a surface of the electrostatic pad apparatus 60 by way of 4 through holes provided at the electrostatic sensor board 101.

Next, an explanation will be given of a connecting relationship between the electrostatic pad apparatus 60 and the push button switch portion 50.

The AV controller 17 is constituted by two independent parts, that is, the electrostatic pad apparatus 60 and the push button switch portion 50. In order to simplify an interface between the two parts and the computer 10, the interface between respectives of the electrostatic pad apparatus 60 and the push button switch portion 50 and the computer 10 is executed by using the one control circuit 302 provided on the back face of the electrostatic board 101.

In order to control the electrostatic pad apparatus 60 and the push button switch portion 50 by the single control circuit 302, the switch board 100 and the electrostatic sensor board 101 are connected to each other by a cable 701 such as a flexible flat cable (FFC). That is, one end of the flexible flat cable (FFC) 701 is connected to a connector 304 provided, for example, on the back face of the switch board 100, and other end of the flexible flat cable (FFC) 701 is connected to a connector 303 provided, for example, on the back face of the electrostatic sensor board 101. A connector 301 is further provided on, for example, the back face of the electrostatic board 101 and the connector 301 and a controller at inside of the computer 10 are connected to each other by a cable 702 such as a flexible flat cable (FFC).

As described above, according to the embodiment, the touch detecting area of the electrostatic pad apparatus 60 is partitioned into a plurality of areas and the areas are allocated with different functions. Therefore, a user can instruct execution of various functions to the software by only carrying out a simple operation of touching the one electrostatic pad apparatus 60 by the finger of the one hand without operating the key board 13, the touch pad 15. Further, the electrostatic pad apparatus 60 is provided with the area allocated with the vertical scroll function and the area allocated with the horizontal scroll function, and therefore, a user can easily navigate the menu screen while scrolling the menu screen or the like displayed by the AV software in the vertical direction or the horizontal direction. Further, the center of the touch detecting area is arranged with the push button switch portion 50 including the enter button and the plurality of direction buttons, and therefore, a number of functions can be provided by the single AV controller 17.

For example, by pushing the OK button 51 in a state of selecting an aimed data item on the menu screen by navigation, reproduction of the data item or the like can be carried out. Further, the direction buttons 52 through 55 are respectively push buttons, a click feeling is provided, and therefore, the direction buttons 52 through 55 can be operated by an operational feeling the same as that of a group of direction keys at inside of the key board 13. Therefore, when a cursor position is moved in an up and down or left and right direction by a small amount, the direction buttons 52 through 55 can be utilized more preferably than the electrostatic button 60.

Further, according to the electrostatic button 60, a cursor moving speed and moving direction are automatically changed in accordance with the touch position at inside of the area 63 allocated with the vertical scroll function. Therefore, a user can properly use easily a fast cursor movement in an upper or lower direction (high speed scroll) and a slow cursor movement in an upper or lower direction (low speed scroll). Similarly, also at inside of the area 64 allocated with the horizontal scroll function, in accordance with the touch position, the cursor moving speed and moving direction are automatically changed. Therefore, a user can properly use easily a fast cursor movement in a left or right direction (high speed scroll) and a slow cursor movement in a left or right direction (low speed scroll).

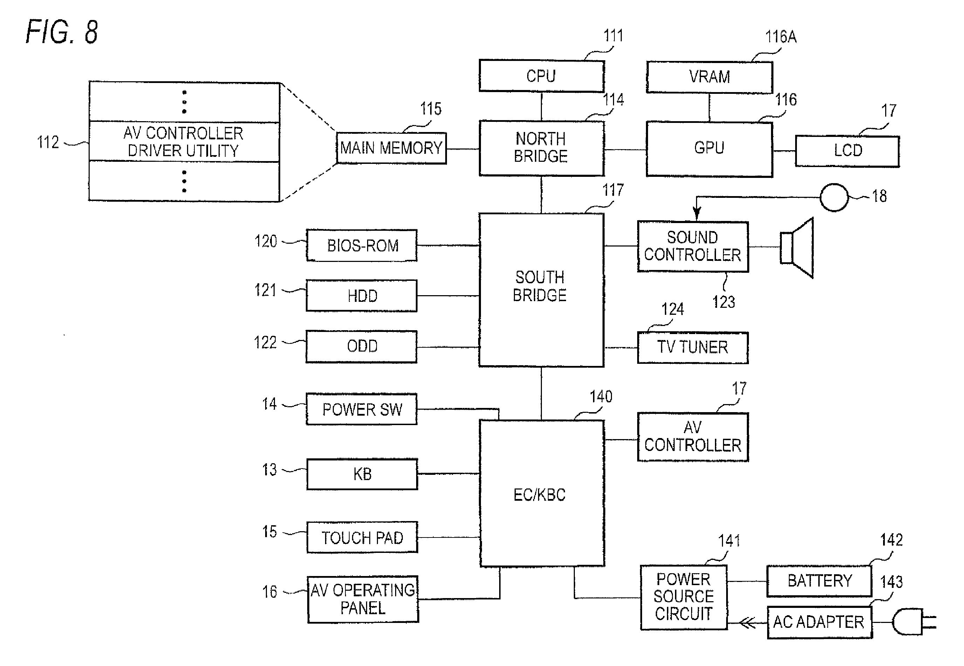

Next, a system constitution of the computer 10 will be explained in reference to Fig.8.

The computer 10 includes CPU 111, a north bridge 114, a main memory 115, a graphics processing unit (GPU) 116, a south bridge 117, BIOS-ROM 120, a hard disk drive (HDD) 121, an optical disk drive (ODD) 122, a sound controller 123, a TV tuner 124, an embedded controller/keyboard controller IC (EC/KBC) 140, and a power source circuit 141 and the like.

CPU 111 is a processor provided for controlling an operation of the computer 10 and executes an operating system and various application programs such as the AV software loaded from HDD 121 to the system memory 115. Further, CPU 111 also executes an AV controller driver utility 112 constituting a program for controlling the AV controller 17. Further, CPU 111 also executes BIOS (Basic Input Output System) stored to BIOS-ROM 120.

The north bridge 114 is a bridge device for connecting a local bus and the south bridge 117. The north bridge 114 also includes a memory controller for controlling to make access to the main memory 115. Further, the north bridge 114 is also provided with a function of executing a communication with the graphics processing unit (GPU) 116 by way of a PCI Express bus or the like.

The graphics processing unit (GPU) 116 is a display controller for controlling LCD 17 used as a display monitor of the computer 10. GPU 116 generates an image signal for forming a screen image to be displayed on LCD 17 from a display data written to a video memory (VRAM) 116A by OS or an application program.

The south bridge 117 includes an IDE (Integrated Drive Electronics) controller or a Serial ATA controller for controlling the hard disk drive (HDD) 121 and the optical disk drive (ODD) 122.

The sound controller 123 is a sound source device for executing a processing of outputting sounds in correspondence with various audio data from a speaker group 19, 20. The TV tuner 124 receives broadcasting program data broadcasted by a TV broadcasting signal.

The embedded controller/keyboard controller IC (EC/KBC) 140 is one chip microcomputer integrated with an embedded controller controlling a power, and a keyboard controller for controlling the keyboard (KB) 13 and the touch pad 15. EC/KBC 140 is always applied with an operating power source from the power source circuit 141 even when a power source of the computer 10 is made OFF. Further, EC/KBC 140 functions as a controller for controlling the AV operating panel 16 and the AV controller 17. A communication between EC/KBC 140 and the AV controller 17 is executed by way of, for example, a serial bus or the like.

Further, EC/KBC 140 is provided with a function of power on/power off the computer 10 in accordance with an operation of a power button switch 14. A control of power on/power off of the computer 10 is executed by a cooperative operation of EC/KBC 140 and the power source 141. The power source circuit 141 generates an operating power source for respective components by using a power from a battery 142 mounted to the computer main body 11, or an AC adapter connected to the computer main body 11 as an external power source.

Next, an explanation will of a relationship between a hardware and a software for controlling the AV controller 17.

As described above, the keyboard 13, the AV operating panel 17, and the AV controller 17 are connected to EC/KBC 140. EC/KBC 140 controls the AV operating panel 16 and the AV controller 17 by executing the AV controller firmware 113. A key code in correspondence with a pushed down key of the keyboard 13 is transmitted to an application program such as the AV software by way of EC/KBC 140 and an operating system (OS). On the other hand, a signal outputted from the AV controller 17 is transmitted to an application program such as the AV software by way of, for example, EC/KBC 140, BIOS, OS, and the AV controller driver utility program 112. In this case, a signal outputted from the AV controller 17 is converted to a command (for example, a code data such as a key code) capable of being interpreted by the application program by the AV controller firmware 113 at inside of EC/KBC 140, or the AV controller driver utility program 112. Naturally, a converting operation may be executed at inside of the control circuit 302 at inside of the AV controller 17. In the following, assume a case in which the converting operation is executed by the AV controller driver utility program 112.

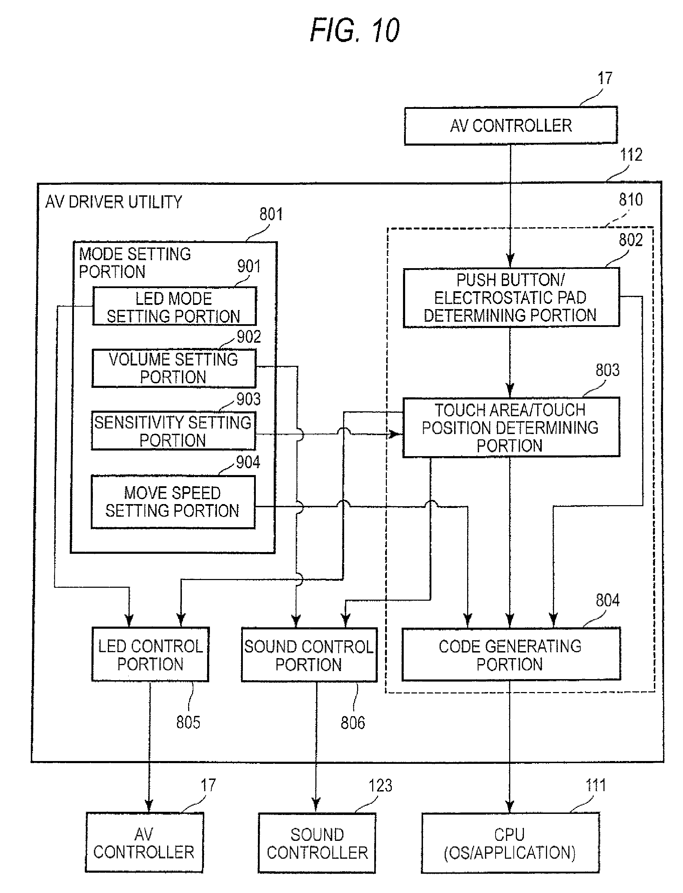

Fig.10 shows a constitution of a function of the AV controller driver utility program 112.

The AV controller driver utility program 112 includes a mode setting portion 801, a push button/electrostatic pad determining portion 802, a touch area/touch position determining portion 803, a code generating portion 804, an LED control portion 805, and a sound control portion 806 as function executing modules.

The mode setting portion 801 is a software module for setting an operational environment of the AV controller 17, and including an LED mode setting portion 901, a volume setting portion 902, a sensitivity setting portion 903, and a Move Speed setting portion 904.

The LED mode setting portion 901 switches an LED mode for controlling to switch on/switch off LEDs 71 through 74 mentioned above between previously prepared two LED modes (first LED mode, second LED mode).

In the first LED mode, respective initial states of LEDs 71 through 74 are switched on. When any of the areas 61 through 64 of the electrostatic pad apparatus 60 is touched by the finger of the user, one of LEDs 71 through 74 in correspondence with the touched area is switched off. For example, when the area 63 is touched, only LED 73 is switched off. LED 73 is switched on again after a predetermined time period has elapsed since the finger of the user has been detached from the area 63. LED 73 is switched off for a constant time period not only when the finger of the user is detached from the area 63 but also when the finger of the user is moved to the dead zone at inside of the area 63.

In the second LED mode, respective initial states of LEDS 71 through 74 are switched off. When any of the areas 61 through 64 of the electrostatic pad apparatus 60 is touched by the finger of the user, one of LEDs 71 through 74 in correspondence with the touched area is switched on. For example, when the area 63 is touched, LED 73 is switched on. LED 73 is switched off again after a predetermined time period has elapsed since the finger of the user has been detached from the area 63. LED 73 is switched on for a constant time period not only when the finger of the user is detached from the area 63 but also when the finger of the user is moved to the dead zone at inside of the area 63.

The volume setting portion 902 sets a volume amount of a sound (touch sound) to be outputted from the speaker when any of the areas 61 through 64 of the electrostatic pad apparatus 60 is touched. When the buttons 51 through 55 at inside of the push button switch portion 50 are operated to push down, although a reaction for the push down operation is conducted to the finger, when the areas 61 through 64 of the electrostatic pad apparatus 60 is operated to be touched, there is not a reaction for the touch operation. Therefore, the touch sound is reproduced only when any of the areas 61 through 64 is touched, and even when any of the buttons 51 through 55 is pushed down, the touch sound is not reproduced.

The sensitivity setting portion 903 sets sensitivities of the areas 61 through 64 of the electrostatic pad apparatus 60. When any of values of electrostatic capacitances of the areas 61 through 64 exceeds a threshold, the electrostatic sensor of the electrostatic pad apparatus 60 detects that an area in which the value of the electrostatic capacitance exceeds the threshold is touched. The sensitivity can be changed by changing, for example, the value of the threshold.

The Move Speed setting portion 904 changes a scroll speed in the vertical direction of the display data when the area 63 allocated with the first "FAST MOVE BUTTON" function is touched, and a scroll speed in the horizontal direction of the display data when the area 64 allocated with the second "FAST MOVE BUTTON" function is touched. Specifically, a cursor moving speed (or operation object position) in correspondence with each subarea at inside of the area 63, that is, a time interval (repeat interval) to continuously issue a key code of the upper arrow mark key "↑" or the lower arrow mark key "↓" when the each subarea at inside of the area 63 is changed. Further, at the same time, a cursor moving speed (or operation object position) in correspondence with each subarea at inside of the area 64, that is, a time interval (repeat interval) to continuously issue a key code of the left arrow mark "←" or the right arrow mark key "right" when the each subarea at inside of the area 64 is touched is also changed. The change in the cursor moving speed in the "FAST MOVE BUTTON" function is executed independently from a processing of setting a repeat interval of each key on the keyboard 13 executed by OS.

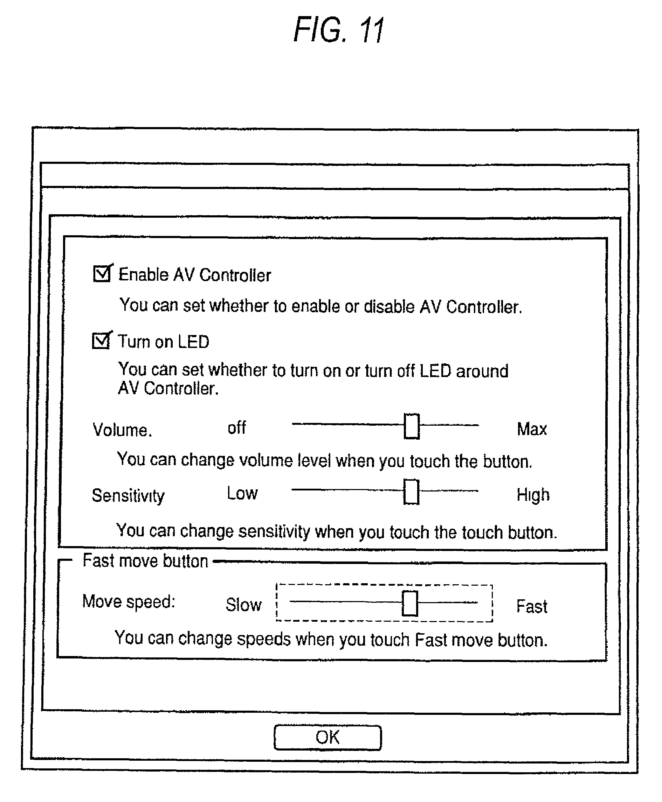

Fig.11 shows an example of a mode setting screen displayed on LCD 17 by the mode setting portion 801.

Setting 1 (ON/OFF setting of AV controller):
When "Enable AV Controller" check box is checked by the user, the function of the AV controller 17 is made ON (enable). When the check of the "Enable AV Controller" check box is removed, the function of the AV controller 17 is made OFF (disable). Default is ON.

### Setting 2 (ON/OFF setting of LED):

When "Turn on LED" check box is checked by the user, the LED mode of is set to a first LED mode. When the check of the "Turn on LED" check box is removed by the user, the LED mode is set to the second LED mode. Default is first LED mode. Also when the LED ON/OFF button of the AV operating panel 16 is touched, the LED mode is switched. At every time of pushing the LED ON/OFF button by the user, the LED mode is switched between the first LED mode and the second LED mode.

### Setting 3 (click volume setting) :

The user can change the sound amount of the click sound by moving a position of a volume setting slider in a left and right direction.

### Setting 4 (sensitivity setting):

The user can change a sensitivities of the respective areas 61 through 64 of the electrostatic pad apparatus 6 by moving a position of a sensitivity setting slider in the left and right direction.

### Setting 5 (moving speed setting):

The user can change the cursor moving speed (position object position moving speed) when the user touches FAST MOVE BUTTON by moving a position of the moving speed setting slider in the left and right direction. When the position of the moving speed setting slider is moved to the right, a key repeat interval when FAST MOVE BUTTON for the low speed scroll is touched, and a key repeat interval when FAST MOVE BUTTON for the high speed scroll are respectively set to be short by predetermined amounts. Further, when the position of the moving speed setting slider is moved to the left, the key repeat interval when FAST MOVE BUTTON for the low speed scroll is touched, and the key repeat interval when FAST MOVE BUTTON for the high speed scroll is touched are respectively set to be long by predetermined amounts.

The push button/electrostatic pad determining portion 802, the touch area/touch position determining portion 803, and the code generating portion 804 function as a control portion 810 for controlling the AV controller 17 including the electrostatic pad apparatus 60 and the push button switch portion 50 in cooperation with EC/KBC 140.

The control portion 810 generates a signal of instructing to execute a function in correspondence with each touched area of the electrostatic pad apparatus 60. For example, when the area 63 of the electrostatic pad apparatus 60 is operated to touch, the control portion issues a signal (command) for scrolling the display data displayed on the display screen in the vertical direction to OS or an application program and issues other signal (command) for scrolling the display data displayed on the display screen in the horizontal direction to OS or an application program when the area 64 is operated to touch.

Further, the control portion 810 is provided with a function of automatically changing a time interval of continuously generating a key code the same as an upper direction key in accordance with touching either of the two upper direction key areas 631, 632 defined at inside of the area 63, and a function of automatically changing the time interval of continuously generating a key code the same as a lower direction key in accordance with touching either of the two lower direction key areas 633, 634 defined at inside of the area 63.

Further, the control portion 810 is provided with a function of automatically changing a time interval of continuously generating a key code the same as a left direction key in accordance with touching either of the two left direction key areas 641, 642 defined at inside of the area 64, and a function of automatically changing a time interval of continuously generating a key code the same as a right direction key in accordance with touching either of the two right direction key areas 643, 644 defined at inside of the area 64.

The push button/electrostatic pad apparatus determining portion 802 receives a signal (ON signal/OFF signal) from the AV controller 17 by way of the AV controller firmware 113. The push button/electrostatic pad determining portion 802 determines that either of the push button switch portion 50 and the electrostatic pad apparatus 60 is operated by the user in accordance with the button number or the coordinates information indicated by the received ON signal.

When the push button switch portion 50 is operated, that is, when any of the OK button 51, the direction buttons 52, 52, 53, 53, 54, 54 is pushed by the user, a signal from the AV controller 17 is transmitted to the code generating portion 804 by way of the push button/electrostatic pad determining portion 802. The code generating portion 804 transmits a command (key code or the like) in correspondence with the button indicated by the signal from the AV controller 17 to OS or an application program executed by CPU 111.

When the electrostatic pad apparatus 60 is operated, that is, when any of the areas 61 through 64 is touched by the finger of the user, an ON signal from the AV controller 17 inputted by way of the AV controller firmware 113 is transmitted to the touch area/touch position determining portion 803 by way of the push button/electrostatic pad determining portion 802. The touch area/touch determining portion 803 determines that any of the areas 61 through 64 is touched in accordance with the button number or the coordinates position indicated by the signal from the AV controller 17. When the touch position on the touch detecting area is the area 63 or the area 64, the touch area or the touch determining portion 803 further determines which subarea is the touch position on the touch detecting area in accordance with the button number or the coordinates position indicated by the signal from the AV controller 17.

When it is determined by the touch area/touch position determining portion 803 that the touch position on the touch detecting area is the area 61, the code generating portion 804 transmits a command in correspondence with the "return" function allocated to the area 61 to OS or an application program executed by CPU 111. Further, when it is determined by the touch area/touch determining portion 803 that the touch position on the touch detecting area is the area 62, the code generating portion 804 transmits a command in correspondence with the "MORE INFO" function allocated to the area 62 to OS or an application program executed by CPU 111.

When it is determined by the touch area/touch position determining portion 803 that the touch position on the touch detecting area is a certain one of the subareas 631 through 634 at inside of the area 63, the code generating portion 804 generates a key code (upper arrow mark key code, lower arrow mark key code) in correspondence with the touched subarea continuously at a predetermined repeat interval in correspondence with the subarea which is detected to be touched, and transmits the respective key codes successively to OS or an application program executed by CPU 111. Operation of continuously outputting the key code is executed continuously during a time period until the finger is detached from the touched subarea, that is, during a time period until the OFF signal is inputted.

When it is determined by the touch area/touch position determining portion 803 that the touch position on the touch detecting area is a certain one of the subareas 641 through 644 at inside of the area 64, the code generating portion 804 generates a key code (left arrow mark key code, or right arrow mark key code) in correspondence with the touched subarea repeatedly at a predetermined repeat interval and transmits the respective key codes successively to OS or an application program executed by CPU 111. The operation of continuously outputting the key code is executed continuously during a time period until the finger is detached from the touched subarea, that is, during a time period until the OFF signal is inputted.

When it is determined by the touch area/touch position determining portion 803 that any of the areas 61 through 64 is touched, the LED control portion 805 transmits a signal instructing to switch ON or switch OFF LED contiguous to the touched area to the AV controller 17. It is determined by a current LED mode whether LED is instructed to be switched ON or switched OFF.

The sound control portion 806 outputs a sound in correspondence with a predetermined touch sound from a speaker by controlling a sound controller 123 when it is determined by the touch area/touch position determining portion 803 that any of the areas 61 through 64 is touched.

Next, an explanation will be given of a processing of inputting an instruction for moving an operation object position or a cursor on a display screen in accordance with operation of the electrostatic pad apparatus 60.

When a user touches certain FAST MOVE BUTTON (subareas 631 through 634, subareas 641 through 644) by the finger, a detecting signal indicating that the FAST MOVE BUTTON is touched is outputted from the electrostatic pad apparatus 60. The detecting signal is inputted to the AV controller driver utility program 112 by way of the AV controller firmware of EC/KBC 140.

The AV controller driver utility program 112 starts a processing of continuously issuing a key code in correspondence with a function allocated to FAST MOVE BUTTON indicated by an ON signal. In this case, the AV controller driver utility program 112 changes an interval of generating the key code (key repeat interval) in accordance with a kind (high speed cursor moving button group, normal cursor moving button group) of FAST MOVE BUTTON indicated by the ON signal. A key repeat interval in correspondence with a high speed cursor moving button group described with the mark "<<"or">>" is shorter than a key repeat interval in correspondence with a normal cursor moving button group described with the mark "<"or">". Further, the AV controller driver utility program 112 can change both of a value of the key repeat interval in correspondence with the high speed cursor moving button group, and a value of the key repeat interval in correspondence with the normal cursor moving button group in accordance with MOVE SPEED set in reference to Fig.11.

When the user detaches the finger from FAST MOVE BUTTON, or when the finger of the user is moved from FAST MOVE BUTTON to the dead zone, an OFF signal indicating that the finger is detached, that is, an OFF signal indicating a button number or a coordinates position of FAST MOVE BUTTON from which the finger is detached is inputted to the AV controller driver utility program 112 by way of the AV controller firmware 113 of EC/KBC 140. At this occasion, the AV controller driver utility program 112 stops generating the key code.

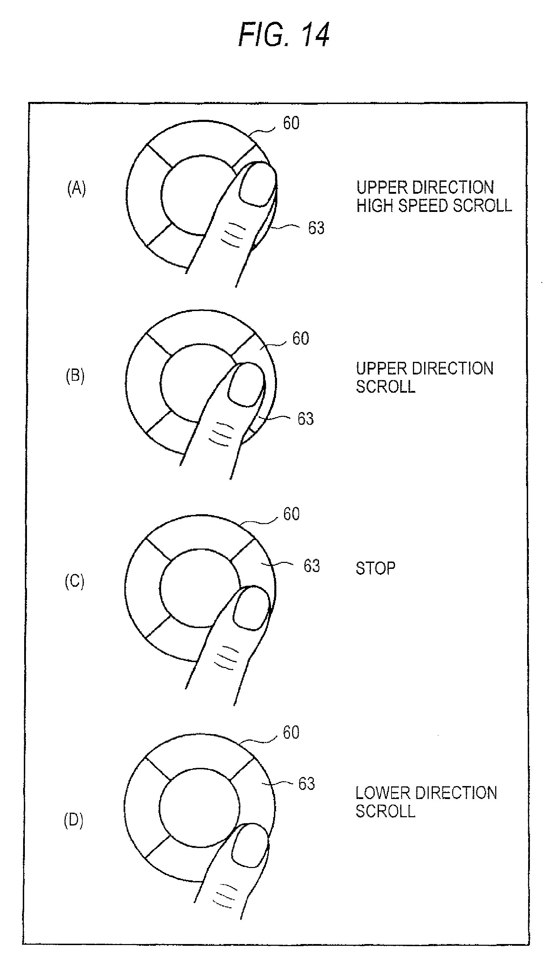

Fig.14 shows examples of a movement of the finger of the user in correspondence with the vertical scroll.

When the finger of the user touches an upper portion (subarea 631) of the area 63 of the electrostatic pad apparatus 60, a key code the same as the upper arrow mark "↑" at inside of the keyboard 13 is continuously generated at a certain short repeat interval, thereby, the cursor (or the position object position) is moved in the upper direction at high speed (upper direction high speed scroll). When the position of the finger of the user is slid from the subarea 631 to the subarea 632 at inside of the area 63 of the electrostatic pad apparatus 60, a key code the same as the upper arrow mark key "↑" at inside of the keyboard 13 is continuously generated by a repeat interval longer than that before being slid. Thereby, the cursor can be moved slowly in the upper direction (upper direction scroll).

When the position of the finger of the user is slid to the center (dead zone) of the area 63 of the electrostatic pad apparatus 60, the key code is stopped from being generated, and the movement of the cursor is stopped. Further, when the position of the finger of the user is slid to the subarea 633 of the area 63, a key code the same as the lower arrow mark key "↓" at inside of the keyboard 13 is continuously generated, thereby, the cursor is moved in the lower direction (lower direction scroll).

In this way, according to the embodiment, the cursor can be operated to move (scroll) more easily than the keyboard 13 by a simple operation of touching the finger to the electrostatic pad apparatus 60 without operating a plurality of arrow marks at inside of the keyboard 13.

A plurality of areas (subareas) having different cursor signal issue intervals are prepared in the same electrostatic pad apparatus 60, and therefore, a fast cursor movement, and a slow cursor movement can properly be used without a special operation of changing settings. Further, since the dead zones are provided between the respective areas, the cursor can be stopped from being moved without detaching the finger from the pad, further, other area different from an aimed area can be prevented from being erroneously touched by the finger. Further, since the function of changing settings of intervals of issuing key code in correspondence with FAST MOVE BUTTON is provided, the cursor can be moved by an arbitrary repeat speed different from a cursor repeat speed of the keyboard 13.

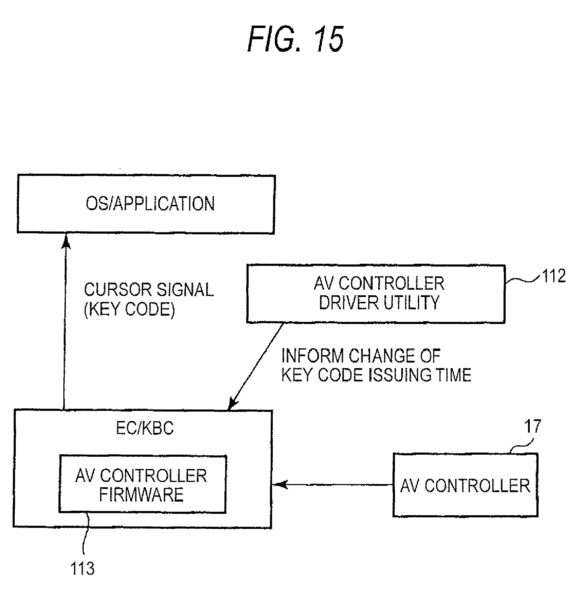

Fig.15 shows a constitution example in correspondence with a case in which the function of the control portion 810 is provided not at the AV controller driver utility program 112 but at the AV controller firmware 113 of EC/KBC 140.

When the user touches certain FAST MOVE BUTTON, an ON signal indicating the FAST MOVE BUTTON, specifically, an ON signal indicating the button number or the coordinates position of the FAST MOVE BUTTON is inputted to the AV controller firmware 113 of EC/KBC 140 from the AV controller 117. The AV controller firmware 113 starts a processing of continuously issuing a key code allocated to FAST MOVE BUTTON indicated by the ON signal. In this case, the AV controller firmware 113 changes an interval of generating a key code (key repeat interval) in accordance with a kind (high speed cursor moving button group, normal cursor moving button group) of FAST MOVE BUTTON indicated by the ON signal. As described above, the key repeat interval in correspondence with the high speed cursor moving button group is shorter than the key repeat interval in correspondence with the normal cursor moving button group. Further, the AV controller firmware 113 changes both of a value of the key repeat interval in correspondence with the high speed cursor moving button group, and a value of the key repeat interval in correspondence with the normal cursor moving button group in accordance with an instruction of changing the repeat interval from the AV controller driver utility program 112.

When the user detaches the finger from FAST MOVE BUTTON, or when the finger of the user is moved to the dead zone from FAST MOVE BUTTON, an OFF signal indicating FAST MOVE BUTTON from which the finger is detached, specifically, an OFF signal indicating the button number or the coordinates position of FAST MOVE BUTTON from which the finger is detached is inputted to the AV controller firmware 113 of EC/KBC 140 from the AV controller 17. The AV controller firmware 113 stops generating the key code.

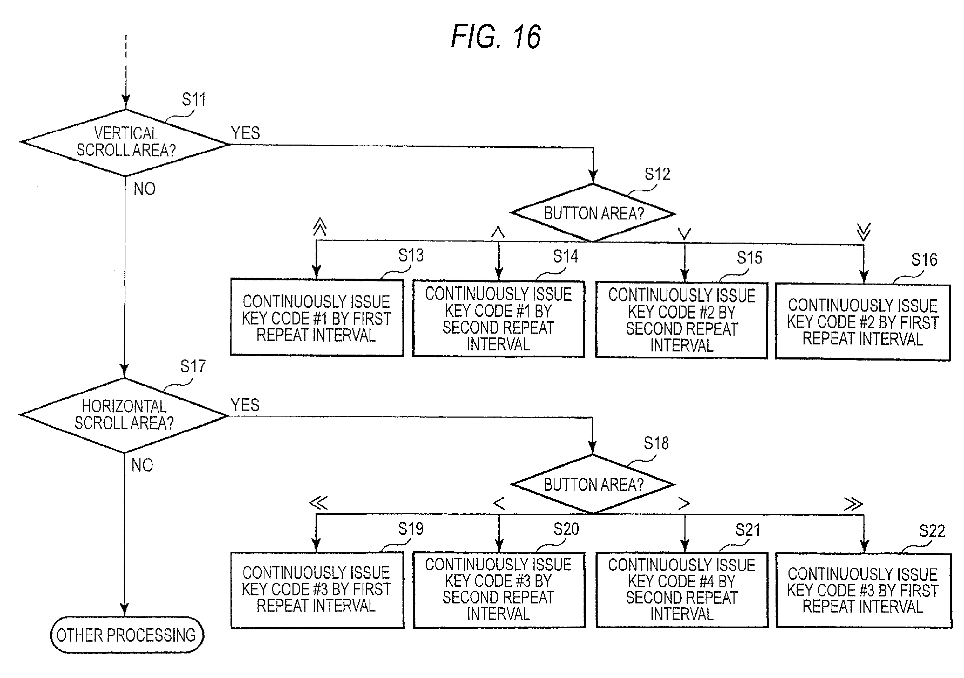

Next, an explanation of the example of a cursor moving processing executed by the AV controller firmware 113 or the AV controller driver utility program 112 will be given in reference to Fig.16. In the following, assume a case in which the AV controller driver utility program 112 executes a cursor moving processing accompanied by continuous generation of a key code.

When an ON signal from the AV controller 17 is received by way of the AV controller firmware 113, the AV controller driver utility program 112 determines whether a touched area is a vertical scroll area (area 63) or the horizontal scroll area (area 64) (steps S11, S12).

When the vertical scroll area (area 63) is touched (YES of step S11), the AV controller driver utility program 112 determines which FAST MOVE BUTTON area (subarea) at inside of the vertical scroll area (area 63) is touched, (step S12).

When the subarea 631 described with the mark "<<" is touched, the AV controller driver utility program 112 continuously transmits a key code the same as the arrow mark key "↑" to OS or an application program by a short repeat interval (first repeat interval) during a time period in which the subarea 631 is being touched (step S13) .

When the subarea 632 described with the mark "<" is touched, the AV controller driver utility program 112 continuously transmits a key code the same as the arrow mark key "↑" to OS or an application program at a repeat interval (second repeat interval) longer than the first repeat interval during a time period in which the subarea 632 is being touched (step S14).

When the subarea 633 described with the mark ">" is touched, the AV controller driver utility program 112 continuously transmits a key code the same as the lower arrow mark key "↓" to OS or an application program by the second repeat interval during a time period in which the subarea 633 is being touched (step S15).

When the subarea 634 described with the mark ">>" is touched, the AV controller driver utility program 112 continuously transmits a key code the same as the lower arrow mark key "↓" to OS or an application program by the first repeat interval during a time period in which the subarea 634 is being touched (step S16).

When the horizontal scroll area (area 64) is touched (YES of step S12), the AV controller driver utility program 112 determines which FAST MOVE BUTTON AREA (subarea) at inside of the horizontal scroll area (area 64) is touched (step S18).

When the subarea 641 described with the mark "<<" is touched, the AV controller driver utility program 112 continuously transmits a key code the same as the left arrow mark key "←" to OS or an application program during a time period in which the subarea 641 is being touched (step S19).

When the subarea 642 described with the mark "<" is touched, the AV controller driver utility program 112 continuously transmits a key code the same as the left arrow mark key "←" to OS or an application program by the second repeat interval longer than the first repeat interval during a time period in which the subarea 642 is being touched (step S20).

When the subarea 643 described with the mark ">" is touched, the AV controller driver utility program 112 continuously transmits a key code the same as the right arrow mark key "→" to OS or an application program by the second repeat interval during a time period in which the subarea 643 is being touched (step S21).

When the subarea 644 described with the mark ">>" is touched, the AV controller driver utility program 112 continuously transmits a key code the same as the right arrow mark key "→" to OS or an application program by the first repeat interval during a time period in which the subarea 644 is being touched (step S22).

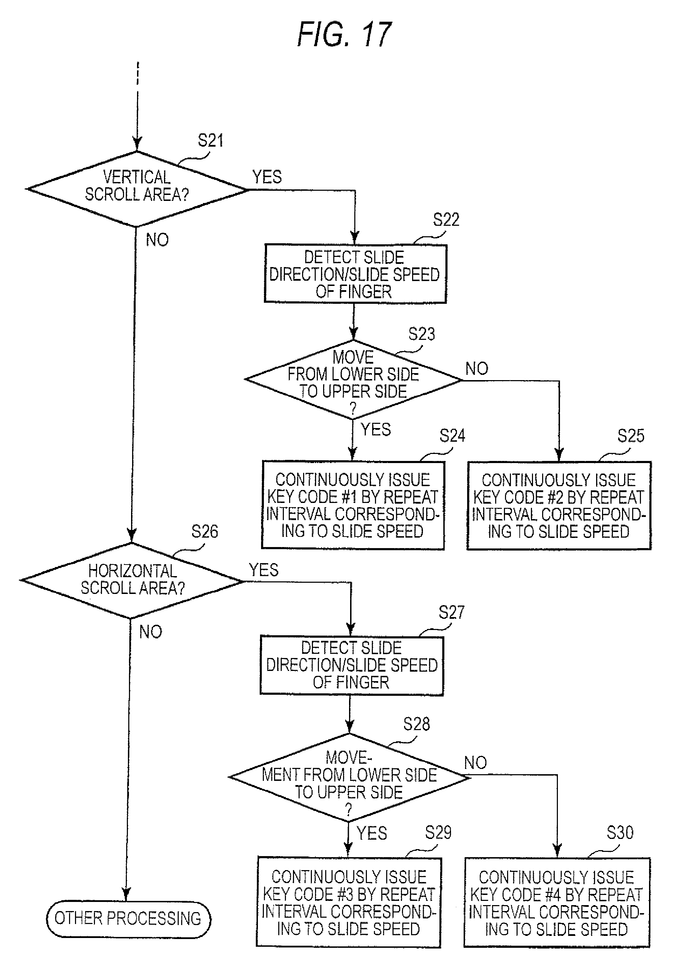

Further, although in the above-described explanation, an explanation has been given of an example of providing a plurality of subareas cursor moving speeds and moving directions of which differ from each other to respectives of the vertical scroll area (area 63) and the horizontal scroll area (area 64), the vertical and the horizontal scrolls can also be executed in accordance with directions of sliding the finger and speeds of the sliding the fingers in respectives of the vertical scroll area (area 63) and the horizontal scroll area (area 64). A processing procedure in this case is shown in a flowchart of Fig.17.

The AV controller 17 successively outputs a signal indicating, for example, a position (coordinates position) of the finger in accordance with a movement (sliding) of the finger on the vertical scroll area (area 63) or the horizontal scroll area (area 64). When a signal indicating a position of the finger transmitted from the AV controller 17 is received by way of the AV controller firmware 113, the AV controller driver utility program 112 determines whether the touched area is the vertical scroll area (area 63) or the horizontal scroll area (area 64) (steps S21, S22).

When the vertical scroll area (area 63) is touched (YES of step S21), the AV controller driver utility program 112 detects a direction of sliding the finger and a speed (moving speed) of sliding the finger based on coordinates positions indicated by respective received signals and amounts of changes per unit time of the coordinates potions (step S22).

Further, the AV controller driver utility program 112 determines whether the direction of sliding the finger is a direction from a lower side to an upper side of the vertical scroll area (area 63) (step S23). When it is determined that the finger is slid in an upper direction from the lower side of the vertical scroll area (area 63) (YES of step S23), the AV controller driver utility program 112 continuously transmits a key code the same as the upper arrow mark key "↑" to OS or an application program by a repeat interval in correspondence with the speed of sliding the finger (step S24) . The faster the speed of sliding the finger, the shorter the repeat interval. Further, even when the finger of the user is moved from the lower side to the upper side while touching the vertical scroll area (area 63), and is stopped at an upper end of the vertical scroll area (area 63), continuous transmission of the key code of the upper arrow mark key "↑" is not stopped but is executed continuously (inertia movement). When the finger of the user is detached from the vertical scroll area (area 63), continuous transmission of the key code of the upper arrow mark key "↑" is stopped.

When it is determined that the finger is moved in an upper direction from an upper side of the vertical scroll area (area 63) (NO of step S23), the AV controller driver utility program 112 continuously transmits a key code the same as the lower arrow mark key "↓" to OS or an application program by a repeat interval in correspondence with the speed of sliding the finger (step S25). The faster the speed of sliding the finger, the shorter the repeat interval. Further, even when the finger of the user is moved from the upper side to the lower side while touching the vertical scroll area (area 63), and is stopped at a lower end of the vertical scroll area (area 63), continuous transmission of the key code of the lower arrow mark key "↓" is not stopped but is executed continuously. When the finger of the user is detached from the vertical scroll area (area 63), continuous transmission of the key code of the lower arrow mark key "↓" is stopped.

Further, instead of detecting the speed of sliding the finger in an up and down direction, a moving amount (sliding amount) of the finger in the up and down direction may be detected and the repeat interval may be changed in accordance with the moving amount.

When the horizontal scroll area (area 64) is touched (YES of step S26), the AV controller driver utility program 112 detects the direction of sliding the finger and the speed (moving speed) of sliding the finger based on, for example, coordinates positions indicated by respective received signals and amounts of changes per unit time of the coordinate positions (step S27).

Further, the AV controller driver utility program 112 determines whether the direction of sliding the finger is a direction from a right side to a left side of the horizontal scroll area (area 64) (step S28). When it is determined that the finger is slid in a left direction from the right side of the horizontal scroll area (area 64) (YES of step S28), the AV controller driver utility program 112 continuously transmits a key code the same as the left arrow mark key "←" at repeat interval in correspondence with the speed of sliding the finger. The faster the speed of sliding the finger, the shorter the repeat interval. Further, even when the finger of the user is moved from the right side to the left side while touching the horizontal scroll area (area 64), and is stopped at a left end of the horizontal scroll area (area 64), continuous transmission of the key code of the left arrow mark key "←" is not stopped but is continuously executed (inertia movement). When the finger of the user is detached from the horizontal scroll area (area 64), continuous transmission of the key code of the left arrow mark key "←" is stopped.

When it is determined that the finger is moved in a right direction from the left side of the horizontal scroll area (area 64) (NO of step S28), the AV controller driver utility program 112 continuously transmits a key code the same as the right arrow mark key "→" to OS or an application program by a repeat interval in correspondence with the speed of sliding the finger (step S30). The faster the speed of sliding the finger, the shorter the repeat interval. Further, even when the finger of the user is moved from the left side to the right side while touching the horizontal scroll area (area 64) and is stopped at a right end of the horizontal scroll area (area 64), continuous transmission of the key code of the right arrow mark key "→" is not stopped but is continuously executed. When the finger of the user is detached from the horizontal scroll area (area 64), continuous transmission of the key code of the right arrow mark key "→" is stopped.

Further, also in the horizontal scroll, instead of detecting the speed of sliding the finger in a left and right direction, a moving amount (sliding amount) of the finger in the left and right direction may be detected, and the repeat interval may be changed in accordance with the moving amount.

Further, the AV controller driver 17 may be constituted only by the electrostatic pad apparatus 60, in this case, execution of various functions can be instructed to the computer 10 by operating only the electrostatic pad apparatus 60.

Further, the invention is not limited to the above-described embodiments as they are but can be embodied by modifying constituent elements within the range not deviated from the gist in an embodying stage. Further, various inventions can be formed by pertinently combining a plurality of constituent elements disclosed in the embodiments. For example, a number of constituent elements may be deleted from all of constituent elements showing the embodiments. Further, constituent elements of different embodiments may pertinently be combined.

## Claims

1. An electrostatic pad apparatus comprising:
a pad portion that includes a touch detecting area having a ringed shape, the touch detecting area being partitioned into a plurality of areas including a first area and a second area, the areas being arranged along a circumferential direction of the touch detecting area; and
a controller that outputs a first command when a touch operation is input to the firs area and outputs a second command when a touch operation is input to the second area.

2. The electrostatic pad apparatus according to claim 1,
wherein the controller outputs the first command for scrolling an image data displayed on a display screen of a display apparatus in a vertical direction when the touch operation is input to the first area, and outputs the second command for scrolling the image data displayed on the display screen in a horizontal direction when the touch operation is input to the second area.

3. The electrostatic pad apparatus according to claim 2,
wherein the first area is partitioned into a first and a second upper direction key area, and a first and a second lower direction key area;
wherein the controller outputs a command for instructing to move an operation target position on the display screen in an upper direction by a first speed when the touch operation is input to the first upper direction key area;
wherein the controller outputs a command for instructing to move the operation target position on the display screen in the upper direction by a second speed that is faster than the first speed when the touch operation is input to the second upper direction key area;
wherein the controller outputs a command for instructing to move the operation target position on the display screen in a lower direction by a third speed when the touch operation is input to the first lower direction key area; and
wherein the controller outputs a command for instructing to move the operation target position on the display screen in the lower direction by a fourth speed that is faster than the third speed when the touch operation is input to the second lower direction key area.

4. The electrostatic pad apparatus according to claim 3,
wherein the second area is partitioned into a first and a second left direction key area, and a first and a second right direction key area;
wherein the controller outputs a command for instructing to move the operation target position on the display screen in a left direction by a fifth speed when the touch operation is input to the first left direction key area;
wherein the controller outputs a command for instructing to move the operation target position on the display screen in the left direction by a sixth speed that is faster than the fifth speed when the touch operation is input to the second left direction key area;
wherein the controller inputs a command for instructing to move the operation target position on the display screen in a right direction by a seventh speed when the touch operation is input to the first right direction key area; and
wherein the controller inputs a command for instructing to move the operation target position on the display screen in the right direction by a eighth speed that is faster than a seventh speed when the touch operation is input to the second right direction key area.

5. The electrostatic pad apparatus according to claim 1 further comprising:
a push button switch portion that is provided at an inner area surrounded by the touch detecting area and includes an enter button and a plurality of direction buttons;
wherein a top face of the push button switch portion is set to be higher than a top face of the touch detecting area.

6. The electrostatic pad apparatus according to claim 5, wherein the pad portion is provided with a projected portion formed along an inner circumference of the touch detecting area.

7. The electrostatic pad apparatus according to claims 1 further comprising:
a first light emitting portion that is arranged adjacent to the first area and switched on or off in response to the touch operation on the first area; and
a second light emitting portion that is arranged adjacent to the second area and switched on and off in response to the touch operation on the second area.

8. An information processing apparatus comprising:
a casing;
an electrostatic pad apparatus that is supported by the casing and including a touch detecting area having a ringed shape, the touch detecting area being partitioned into a plurality of areas including a first area and a second area, the areas arranged along a circumferential direction of the touch detecting area; and
a controller that outputs a first signal for scrolling an image data displayed on a display screen in a vertical direction when a touch operation is input to the first area and outputs a second signal for scrolling the image data displayed on the display screen in a horizontal direction when the touch operation is input to the second area.

9. The information processing apparatus according to claim 8,
wherein the first area is partitioned into a first and a second upper direction key area and a first and a second lower direction key area;
wherein the controller outputs a signal for moving an operation target position on the display screen in an upper direction by a first speed when the touch operation is input to the first upper direction key area;
wherein the controller outputs a signal for moving the operation target position on the display screen in the upper direction by a second speed that is faster than the first speed when the touch operation is input to the second upper direction key area;
wherein the controller outputs a signal for moving the operation target position on the display screen in a lower direction by a third speed when the touch operation is input to the first lower direction key area; and
wherein the controller outputs a signal for moving the operation target position on the display screen in the lower direction by a fourth speed that is faster than the third speed when the touch operation is input to the second lower direction key area.

10. The electrostatic pad apparatus according to claim 8 further comprising:
a push button switch portion that is provided at an inner area surrounded by the touch detecting area and includes an enter button and a plurality of direction buttons,
wherein a top face of the push button switch portion is set to be higher than a top face of the touch detecting area.
